# FASCICULE DE BREVET EUROPEEN

(11) **EP 0 527 459 B1**
(45) Date de publication et mention de la délivrance du brevet: **31.01.1996**
(21) Numéro de dépôt: 92113578.6
(22) Date de dépôt: 10.08.1992
(51) Int. Cl.: H01R 13/658, H01R 13/74

(54) **Joint d'étanchéité, notamment d'étanchéité électromagnétique**
Dichtungsanordnung, insbesondere elektromagnetische Abschirmung
Gasket arrangement in particular electromagnetic shield

(30) Priorité: 14.08.1991 FR 9110339
(43) Date de publication de la demande: 17.02.1993
(73) Titulaire: ALCATEL CIT, F-75008 Paris (FR)
(72) Inventeur: Jamet, Daniel, F-91620 Nozay (FR); Verdurand, Rémi, F-92200 Neuilly (FR)
(74) Mandataire: Weinmiller, Jürgen

(56) Documents cités:
- EP-A- 0 073 112
- DE-A- 2 613 907
- US-A- 4 006 872
- US-A- 4 583 808
- US-A- 4 708 412

## Description

La présente invention concerne un joint d'étanchéité, notamment pour l'assemblage du boîtier métallique de protection d'un connecteur électrique à un écran de protection contre les perturbations électromagnétiques (voir par exemple US-A-4708412).

Pour assurer la protection contre les perturbations électromagnétiques d'équipements électroniques tels que des équipements de télécommunication par exemple, il est connu de munir les châssis ou les bâtis de ces équipements d'écrans métalliques de protection, les liaisons, internes ou externes à ces bâtis ou à ces châssis, de blindages métalliques de protection, et les éléments de connexion de ces diverses liaisons, de boîtiers métalliques de protection assurant une mise du blindage des liaisons ainsi raccordées par ces éléments de connexion, à la masse de ces boîtiers.

Ces boîtiers ont en outre généralement une forme déterminée pour pouvoir, notamment dans le cas d'éléments de connexion électrique utilisés pour raccorder des liaisons externes à un bâti ou à un châssis à des liaisons internes à ce bâti ou à ce châssis, établir une continuité électrique entre ces boîtiers et l'écran de protection de ce bâti ou ce châssis, à l'endroit des ouvertures pratiquées dans cet écran pour le passage de ces éléments de connexion munis de leurs boîtiers.

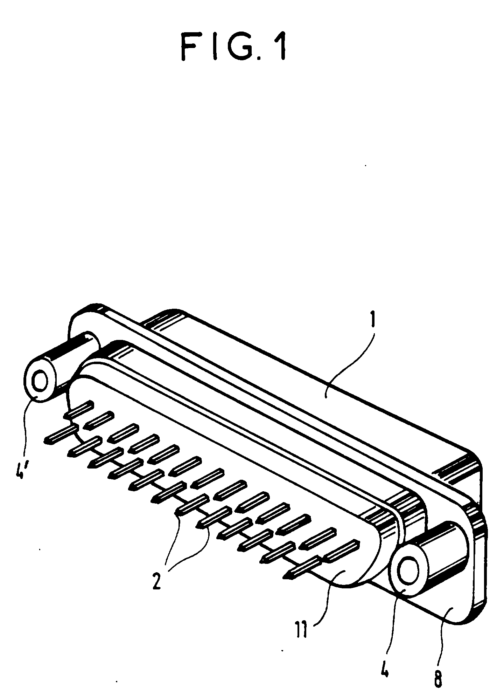

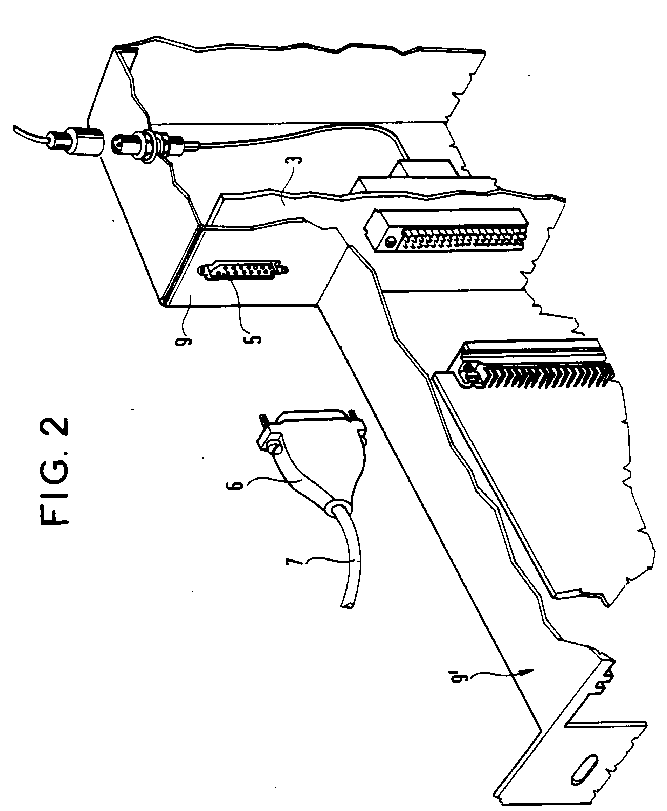

Dans ce qui suit on considérera plus particulièrement, à titre d'exemple, un connecteur multicontact tel que celui représenté en perspective sur la figure 1, qui est muni d'une première série de contacts tels que 2 enrobés dans une enveloppe 11 en plastique moulé, venant, dans l'application à un bâti ou châssis d'équipement électronique rappelée ci-dessus et illustrée sur la figure 2, se placer dans des trous correspondants d'une carte de circuit imprimé 3 interne ici à un châssis et appelée fond de panier, et d'une deuxième série de contacts, en correspondance avec la première série, tels que 5, visibles sur cette figure 2 seulement, du fait de l'orientation différente du connecteur sur ces deux figures, et destinés au raccordement à un connecteur complémentaire équipant une prise blindée 6 de raccordement à un câble 7 externe au châssis.

Un boîtier métallique de protection repéré 1 épouse la forme de l'enveloppe 11 en plastique sur la majorité de son pourtour en laissant une partie non recouverte à proximité de la surface où apparaissent en saillie les contacts 2. Cette disposition permet l'introduction desdits contacts jusqu'en butée de ladite surface dans les trous prévus de la carte de circuit imprimé sans pour cela occasionner des court-circuits entre les pistes dudit circuit, passant à proximité. Le boîtier métallique 1 présente sur son pourtour, sensiblement à sa partie médiane dans le sens de la profondeur sur ces figures, un épaulement plan 8 destiné à servir de surface d'appui contre une plaque métallique encore appelée platine et formée d'une partie, repérée 9, de l'écran de protection repéré 9', située en retrait, parallèlement au fond de panier 3, et à une distance de celui-ci suffisante pour permettre l'insertion de tels connecteurs munis de boîtiers métalliques de protection dont un seul est ainsi représenté sur la figure 2, une fois mis en place.

Ce connecteur multicontacts et son boîtier métallique de protection ont en outre une forme oblongue, et cet épaulement plan a en l'occurence, comme illustré sur la figure 1, une hauteur relativement faible sur la partie longitudinale du boîtier, et une largeur relativement plus importante sur la partie transversale de ce boîtier, où il est muni de moyens pour sa fixation au fond de panier 3, ces moyens étant en l'occurence figurés par deux colonnettes de fixation filetées, 4, 4' destinées à coopérer avec des vis, non représentées sur cette figure.

Pour accroître la qualité de la liaison électrique entre la platine 9 et cet épaulement 8 une fois ces deux éléments ainsi assemblés l'un à l'autre, il est connu, en vue d'accroître la protection de l'équipement considéré contre les perturbations électromagnétiques, d'utiliser une pièce intermédiaire appelée joint d'étanchéité électromagnétique.

Il est ainsi connu de réaliser un tel joint au moyen d'une feuille métallique de forme oblongue, munie d'une ouverture de forme oblongue adaptée pour pouvoir recevoir ledit boîtier tout en le maintenant par ledit épaulement, ladite feuille présentant en outre sur la partie longitudinale du pourtour de cette ouverture, en section longitudinale, des ondulations destinées à assurer ladite liaison électrique entre platine et épaulement.

Il est aussi connu de réaliser un tel joint au moyen d'une feuille métallique de forme oblongue, munie d'une ouverture de forme oblongue adaptée pour pouvoir recevoir ledit boîtier tout en le maintenant par ledit épaulement, ladite feuille étant en outre découpée sur le pourtour de cette ouverture, pour former un ensemble de lamelles destinées à assurer ladite liaison électrique entre platine et épaulement.

De tels joints bien qu'élastiques ne permettent cependant pas, d'établir une liaison électrique de qualité suffisante entre platine et épaulement, notamment dans le cas où, en l'absence de tout joint, il resterait un espace libre relativement important entre cette platine et cet épaulement une fois le connecteur monté sur le fond de panier, puis la platine fixée à ce fond de panier. Un tel espace peut être dû par exemple à l'utilisation de plusieurs types de connecteurs, de dimensions différentes, destinés à être assemblés à la même platine, ou à un défaut de planéité de cette platine, du fait de la surface relativement grande occupée par celle-ci, ce défaut de planéité étant particulièrement gênant dans le cas où, chaque connecteur étant fixé individuellement au fond de panier seul, ladite platine n'est elle-même fixée au fond de panier ou éventuellement à des montants du châssis auxquels est également fixé le fond de panier, que par une simple fixation, par exemple en quelques points situés à la périphérie de cette platine.

La présente invention a pour but la réalisation d'un joint d'étanchéité élastique, qui soit applicable au cas de connecteurs munis de boîtiers métalliques de protection de forme oblongue, tels que les connecteurs multicontacts du type illustré sur les figures 1 et 2, et qui permette dans ce cas d'obtenir une meilleure qualité de liaison électrique entre la platine et les boîtiers de connecteurs que celle obtenue avec les joints connus.

La présente invention a pour objet un joint d'étanchéité, pour l'assemblage d'un premier élément tel qu'un boîtier de protection d'un connecteur électrique contre les perturbations électromagnétiques, de forme oblongue et muni sur son pourtour d'une surface d'appui dite première surface d'appui à un second élément, tel qu'un écran de protection contre les perturbations électromagnétiques, muni d'une ouverture adaptée pour pouvoir recevoir ledit premier élément tout en le retenant par ladite première surface d'appui, le pourtour de ladite ouverture formant lui-même une surface d'appui dite seconde surface d'appui, ledit joint d'étanchéité comportant une feuille métallique de forme oblongue, munie de deux pliures suivant deux axes longitudinaux dits de pliage, définissant sur cette feuille deux ailes latérales inclinées par rapport à un panneau central, suivant une inclinaison permettant aux bords de ces ailes latérales de pouvoir venir en appui contre ladite seconde surface d'appui sous l'action d'une force exercée lors de l'assemblage et tendant à ramener ladite feuille à son état avant pliage, ladite feuille étant en outre munie d'une ouverture de forme oblongue adaptée pour pouvoir recevoir ledit premier élément, et ayant en outre une largeur légèrement inférieure à l'écartement desdits axes de pliage, de façon à ce que, les parties du panneau central situées sur la partie transversale du pourtour de l'ouverture de la feuille ayant été, avant pliage, dégagées de celles situées sur la partie longitudinale du pourtour de cette ouverture et comprises entre les axes de pliage et cette ouverture, ces dernières puissent former un prolongement desdites ailes latérales dans la région de l'ouverture de la feuille, de même inclinaison que celles-ci et apte à venir en appui contre ladite première surface d'appui sous l'action de ladite force.

D'autres objets et caractéristiques de la présente invention apparattront à la lecture de la description suivante d'exemples de réalisation, faite en relation avec les dessins ci-annexés dans lesquels, outre les figures 1 et 2 décrites ci-dessus et représentant respectivement une vue en perspective d'un exemple de connecteur de forme oblongue auquel s'applique le joint d'étanchéité suivant l'invention, et une vue en perspective, partiellement arrachée, montrant une utilisation d'un tel connecteur dans un châssis d'équipement électronique,
- la figure 3 illustre, suivant une vue en perspective éclatée, un mode de montage d'un connecteur muni d'un boîtier métallique de protection tel que celui illustré sur la figure 1, utilisant un joint d'étanchéité électromagnétique suivant l'invention,
- la figure 4 est une vue de face (par référence à la vue en perspective de la figure 3) du joint d'étanchéité suivant l'invention,
- la figure 5 est une vue en coupe suivant l'axe X-X' de la figure 3, cette vue étant simplifiée dans le seul but de faire ressortir les points de contact de la liaison électrique entre la platine et le boîtier, par l'intermédiaire du joint d'étanchéité suivant l'invention, au cours de l'assemblage.

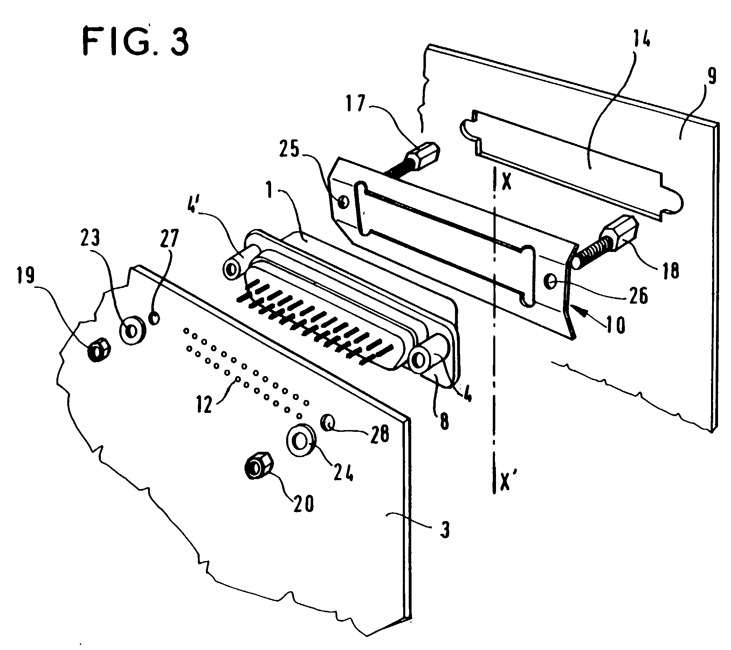

Sur la figure 3 sont représentés, à l'état non assemblé et dans un ordre inversé par rapport à la figure 2, le fond de panier 3, l'ensemble du connecteur et notamment son boîtier 1, et la platine 9, après leur avoir en outre fait subir une rotation de 90° dans le plan de la feuille par rapport à leur position illustrée sur la figure 2.

Sur la figure 3 sont ainsi visibles les trous tels que 12 pratiqués dans le fond de panier 3, et destinés à recevoir les contacts, ou broches, tels que 2, de ce connecteur.

Sur la figure 3 est en outre référencée 14 une ouverture pratiquée dans la platine 9 et destinée à recevoir le boîtier 1 du connecteur tout en le retenant par son épaulement 8.

Dans l'exemple d'assemblage illustré sur la figure 3, le boîtier 1 est tout d'abord fixé, par son épaulement 8, au fond de panier 3, au moyen d'une part de vis 17, 18 adaptées aux colonnettes filetées 4, 4' et d'autre part de rondelles 23 et 24 et écrous 19, 20, le fond de panier 3 étant muni de trous en correspondance, respectivement 27, 28, pour le passage des vis 17, 18.

Le joint d'étanchéité suivant l'invention, repéré 10, prend place entre cet épaulement et la platine et est également muni de trous 25, 26 pour le passage des vis 17, 18.

Une fois l'assemblage fond de panier-boîtier-joint ainsi réalisé, la platine 9 est alors simplement posée contre le joint 10, avant d'être elle-même fixée par exemple au fond de panier 3, par des moyens de fixation non représentés ici, et selon une opération qui peut alors être unique pour une pluralité de connecteurs à assembler de cette façon entre la même platine et le même fond de panier 3.

L'ouverture 14 pratiquée dans la platine 9 se prolonge en l'occurence par des lumières, repérées 27, 28, permettant d'accéder aux vis 17, 18 une fois la platine mise en place.

Le joint suivant l'invention a, ainsi qu'il va maintenant être décrit, une structure élastique telle qu'elle permet d'améliorer la qualité de la liaison électrique entre la platine et l'épaulement du boîtier de connecteur, non seulement à l'endroit du contact entre ce joint et la platine, mais aussi à l'endroit du contact entre ce joint et l'épaulement, et ce même dans le cas d'un relativement important espace libre qui resterait, en l'absence de joint, entre cet épaulement et cette platine, une fois le connecteur monté sur le fond de panier puis la platine fixée au fond de panier.

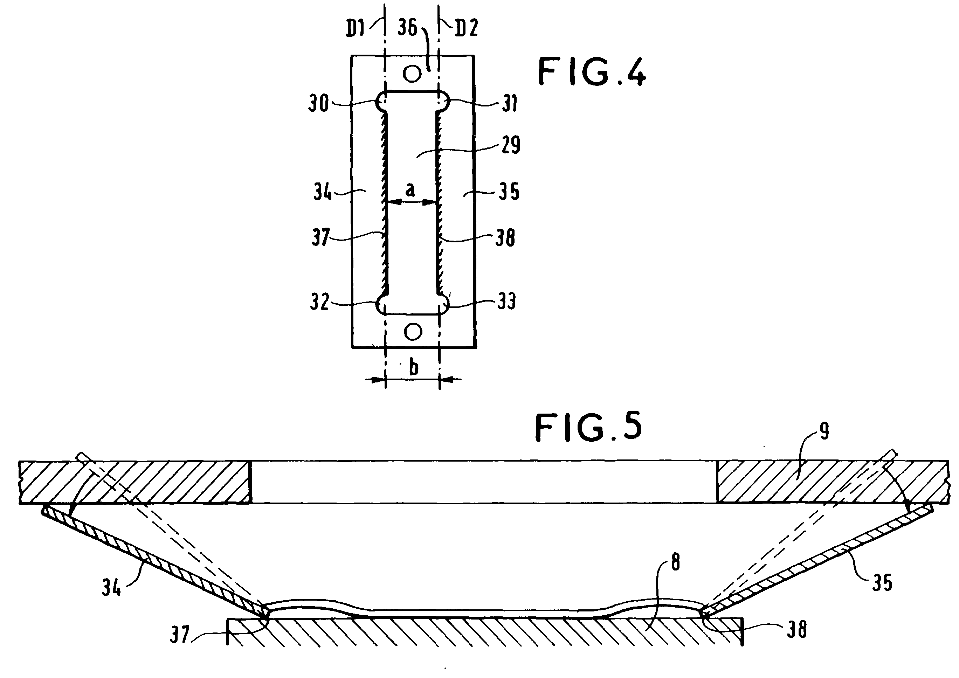

Comme illustré sur la figure 4, ce joint est en effet réalisé à partir d'une feuille métallique de forme oblongue, qui a été évidée, sensiblement dans sa partie centrale, pour former une ouverture, repérée 29, adaptée pour pouvoir recevoir le boîtier de connecteur, ainsi que des dégagements, repérés 30, 31, 32, 33, permettant d'éviter un contact entre les parties transversale et longitudinale du pourtour de cette ouverture, et qui a ensuite été pliée, à l'endroit de ces dégagements, suivant deux axes longitudinaux, dits de pliage, repérés D1 et D2, tels que l'écartement "b" de ces axes soit légèrement supérieur à la largeur "a" de l'ouverture, de façon à définir deux ailes latérales, 34 et 35, inclinées par rapport à un panneau central 36, et se prolongeant, dans la région de l'ouverture, par les parties, représentées hachurées pour une meilleure compréhension et repérées 37 et 38, comprises entre les axes de pliage et l'ouverture, et de même inclinaison que ces ailes latérales.

Ainsi, lorsque la platine et l'épaulement sont plaqués l'un contre l'autre, par l'intermédiaire de ce joint, sous l'action d'une force exercée lors de l'assemblage, en l'occurence lors de la fixation de la platine au fond de panier par exemple, et tendant à ramener ladite feuille à son état avant pliage, et comme illustré sur la figure 5, les ailes latérales 34 et 35 viennent en appui, et glissent, par leurs bords respectifs, contre la platine, et les parties 37 et 38 viennent en appui et glissent contre l'épaulement 8, grâce à quoi on obtient un très bon contact d'une part entre joint et platine, et d'autre part entre Joint et épaulement, au moins sur la partie longitudinale du pourtour de l'ouverture. Il s'en suit une très bonne liaison électrique entre boîtier du connecteur et platine de protection du châssis.

## Revendications

1. Joint d'étanchéité, pour l'assemblage d'un premier élément tel qu'un boîtier (1) de protection d'un connecteur électrique contre les perturbations électromagnétiques, de forme oblongue et muni sur son pourtour d'une surface d'appui (8) dite première surface d'appui, à un second élément, tel qu'un écran de protection contre les perturbations électromagnétiques, muni d'une ouverture adaptée pour pouvoir recevoir ledit premier élément tout en le retenant par ladite première surface d'appui, le pourtour de ladite ouverture formant lui-même une surface d'appui dite seconde surface d'appui, ledit joint d'étanchéité comportant une feuille métallique de forme oblongue, munie de deux pliures suivant deux axes longitudinaux (D1, D2) dits de pliage, définissant sur cette feuille deux ailes latérales (34, 35) inclinées par rapport à un panneau central (36), suivant une inclinaison permettant aux bords de ces ailes latérales de pouvoir venir en appui contre ladite seconde surface d'appui sous l'action d'une force exercée lors de l'assemblage et tendant à ramener ladite feuille à son état avant pliage, ladite feuille étant en outre munie d'une ouverture (29) de forme oblongue adaptée pour pouvoir recevoir ledit premier élément, et ayant en outre une largeur (a) légèrement inférieure à l'écartement (b) desdits axes de pliage, de façon à ce que, les parties du panneau central situées sur la partie transversale du pourtour de l'ouverture de la feuille ayant été, avant pliage, dégagées de celles (37, 38) situées sur la partie longitudinale du pourtour de cette ouverture et comprises entre les axes de pliage et cette ouverture, ces dernières puissent former un prolongement desdites ailes latérales dans la région de l'ouverture de la feuille, de même inclinaison que celles-ci et apte à venir en appui contre ladite première surface d'appui sous l'action de ladite force.

## Patentansprüche

1. Dichtung für das Zusammenfügen eines ersten länglichen Elements, z.B. eines Gehäuses zum Schutz eines elektrischen Verbinders gegen elektromagnetische Störungen, das auf seinem Umfang eine erste Auflagefläche (8) zur Anlage auf einem zweiten Element aufweist, zum Beispiel einem Schutzschirm gegen elektromagnetische Störungen, der eine Öffnung aufweist, um das erste Element aufzunehmen und es gegen die erste Auflagefläche drückt, wobei der Umfang der Öffnung selbst eine zweite Auflagefläche bildet und die Dichtung ein längliches Metallblech aufweist, das zwei Falten gemäß zwei Falt-Längsachsen (D1, D2) aufweist, die auf diesem Blech zwei Seitenflügel definieren, die in Bezug auf eine zentrale Platte (36) so geneigt sind, daß die Ränder dieser Seitenflügel gegen die zweite Auflagefläche in Anlage kommen können unter der Wirkung einer Kraft, die beim Zusammenfügen ausgeübt wird und die das Blech in seinen Zustand vor der Faltung bringen möchte, wobei das Blech außerdem eine längliche Öffnung (29) aufweist, in die das erste Element eindringt, und die außerdem geringfügig weniger breit (a) als der Abstand (b) der Faltachsen ist, so daß, da die Teile der zentralen Platte, die sich auf dem Querbereich des Umfangs der Öffnung des Blechs befinden, vor dem Falten von den Teilen (37, 38) auf dem Längsbereich des Umfangs dieser Öffnung abgesetzt wurden, die zwischen den Faltachsen und dieser Öffnung liegen, diese letzteren Teile eine Verlängerung der Seitenflügel im Bereich der Öffnung des Blechs mit der gleichen Neigung wie diese bilden können und gegen die erste Auflagefläche unter der Einwirkung der genannten Kraft anliegen können.

## Claims

1. Seal for attaching a first member such as an oblong electrical connector housing (1) providing protection against electromagnetic interference having a first bearing surface (8) at its edge to a second member such as an electromagnetic interference protection shield including an opening adapted to receive said first member and retain it by virtue of engagement with said first bearing surface, the edge of said opening itself forming a second bearing surface, said seal comprising an oblong metal plate bent along two longitudinal bending axes (D1, D2) defining on said plate two lateral flanges (34, 35) inclined relative to a central panel (36) with an inclination enabling the edges of said lateral flanges to bear against said second bearing surface on application of a force during assembly tending to return said plate to its shape before bending, said plate further comprising an oblong opening (29) adapted to receive said first member and having a width (a) slightly less than the distance (b) between said bending axes so that parts of the central panel situated on the transverse edges of the opening in the plate which before bending are separated from those (37, 38) situated on the longitudinal edges of the opening and between the bending axes and the opening are adapted to form an extension of said lateral flanges in the region of the opening in the plate with the same inclination as the latter and adapted to bear against said first bearing surface on application of said force.
